# EUROPÄISCHE PATENTSCHRIFT

(11) **EP 0 603 739 B1**
(45) Veröffentlichungstag und Bekanntmachung des Hinweises auf die Patenterteilung: **25.10.1995**
(21) Anmeldenummer: 93120259.2
(22) Anmeldetag: 16.12.1993
(51) Int. Cl.: H05K 1/18

(54) **Spannungsfeste Elektronik-Baugruppe**
Stress resistant electronic assembly
Ensemble électronique résistant aux contraintes mécaniques

(30) Priorität: 23.12.1992 DE 4243829
(43) Veröffentlichungstag der Anmeldung: 29.06.1994
(73) Patentinhaber: Rheinmetall Industrie Aktiengesellschaft, 40880 Ratingen (DE)
(72) Erfinder: Lamers, Johannes, D-41472 Neuss (DE); von der Lippe, Norbert, D-47443 Moers (DE); Sommer, Peter, D-47269 Duisburg (DE); Stoffels, Dietmar, D-40591 Düsseldorf (DE); Wegener, Jürgen, D-41749 Viersen (DE)

(56) Entgegenhaltungen:
- WO-A-89/09534
- PATENT ABSTRACTS OF JAPAN vol. 16, no. 435 (E-1263)10. September 1992 & JP-A-04 152 592 (TAMURA SEISAKUSHO CO LTD) 26. Mai 1992
- PATENT ABSTRACTS OF JAPAN vol. 16, no. 435 (E-1263)10. September 1992 & JP-A-04 152 589 (TAMURA SEISAKUSHO CO LTD) 26. Mai 1992
- DATABASE WPI Section Ch, Week 9008, 10. Januar 1990 Derwent Publications Ltd., London, GB; Class A12, AN 90-056519 ANONYMOUS 'Solder joint life improvement unsing adhesive'
- PATENT ABSTRACTS OF JAPAN vol. 16, no. 478 (E-1274)5. Oktober 1992 & JP-A-04 171 790 (TAMURA SEISAKUSHO CO LTD) 18. Juni 1992
- PATENT ABSTRACTS OF JAPAN vol. 16, no. 435 (E-1263)10. September 1992 & JP-A-04 152 588 (TAMURA SEISAKUSHO CO LTD) 26. Mai 1992

## Beschreibung

Die Erfindung betrifft eine Elektronik-Baugruppe nach dem Oberbegriff der Ansprüche 1 und 2.

Aus der DE-A- 40 38 460 ist eine beschleunigungsfeste Elektronik-Baugruppe bekannt, die eine mit Leiterbahnen versehene Stahlhybrid-Leiterplatte aufweist, auf der ein oder mehrere elektronische SMD-Bauteile (oberflächenmontierte Bauteile) mittels punktförmiger Klebestellen befestigt sind. Die elektrischen Anschlüsse der SMD-Bauteile sind mit den zugehörigen Leiterbahnen der Leiterplatte, z.B. unter Zwischenschaltung von flächenhaften, flexiblen Anschlußbahnen-Folien (vgl. DE-A- 38 38 085), verlötet.

Nachteilig ist bei dieser bekannten Anordnung, daß bei Verwendung relativ großer Baugruppen mit entsprechend hoher elektronischer Integration und hohem Gewicht, wie sie etwa für intelligente zielsuchende Geschosse benötigt wird, die Verschußfestigkeit häufig nicht gewährleistet ist.

Aufgabe der vorliegenden Erfindung ist es daher, eine verschußfeste Elektronik-Baugruppe zu schaffen, die auch bei Verwendung relativ großer Baugruppen unter extremen Belastungen funktionstüchtig in entsprechender Munition verschießbar ist.

Diese Aufgabe wird entsprechend den kennzeichnenden Teilen der Ansprüche 1 und 2 gelöst.

Im wesentlichen liegt der Erfindung der Gedanke zugrunde, nicht nur die elektronischen Bauelemente elastisch an der Leiterplatte zu befestigen, sondern zusätzlich auch die Leiterplatte elastisch an einem Auflager anzuordnen. Hierzu kann eine elastische Klebeschicht, vorzugsweise eines Silikonklebers, dienen, dessen Stärke mindestens 3 mm, vorzugsweise 5 bis 10 mm, betragen sollte. Statt der Klebeschicht können auch punktförmige Klebestellen entsprechender Stärke verwendet werden.

Bei einer vorteilhaften Weiterbildung der Erfindung erfolgt die elastische Anordnung der Leiterplatte an dem Auflager über eine Folie aus einem zelligen geschäumten Polyurethan-Elastomer, wie sie beispielsweise von der Fa. Elastogran GmbH, Lemförde, Deutschland, unter der Bezeichnung Cellasto hergestellt und vertrieben wird. Die Folienstärke sollte etwa zwischen 0,5 und 3 mm, vorzugsweise zwischen 1 bis 2 mm, liegen.

Als Leiterplattenmaterial haben sich besonders glasfaser- oder kohlefaserverstärkte Kunststoffplatten bewährt. Allerdings können auch Materialien aus einem Keramik- oder einem Stahlhybrid verwendet werden.

Besonders bei relativ großen elektronischen Bauteilen hat es sich als vorteilhaft erwiesen, wenn zwischen das jeweilige elektronische Bauteil und die Leiterplatte statt punktförmiger Klebestellen eine elastische Zwischenscheibe als Federelement geklebt wird.

Weitere Einzelheiten und Vorteile der Erfindung ergeben sich aus den Unteransprüchen und den folgenden anhand von Figuren erläuterten Ausführungsbeispielen. Es zeigen:
- Fig.1: schematisch den Aufbau eines ersten Ausführungsbeispieles einer verschußfesten Elektronik-Baugruppe;
- Fig.2: die Kraftvektoren in der Abschußphase von Artilleriemunition;
- Fig.3: die Kräfte und die Verformung in der Elektronik-Baugruppe beim Abschuß für das in Fig.1 dargestellte Ausführungsbeispiel;
- Fig.4: schematisch den Aufbau einer zweiten erfindungsgemäßen Elektronik-Baugruppe und
- Fig.5: die Anordnung eines abzustützenden elektronischen Bauteiles auf einer Leiterplatte.

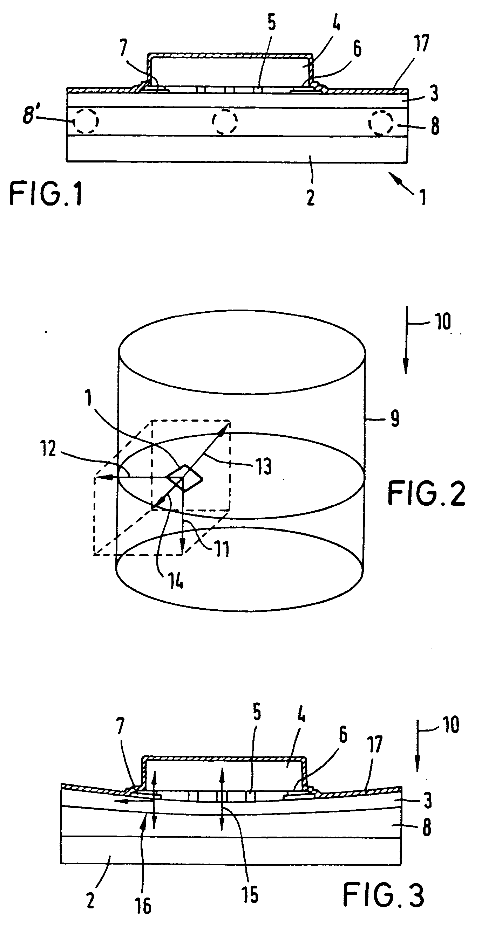

Die in Fig.1 dargestellte verschußfeste Elektronik-Baugruppe 1 umfaßt ein Auflager 2 und eine Leiterplatte 3 aus einem glasfaser- oder kohlefaserverstärktem Kunststoffmaterial (beispielsweise FR4 oder DYCOstrate ™ der Fa. Dycnex AG, Zürich, Schweiz). Auf der Leiterplatte 3 ist ein hochintegriertes Bauteil (IC) 4 mittels Klebepunkten 5 aus einem elastischen Klebstoff (vorzugsweise einem Silikonkleber) befestigt. Die elektrischen Anschlüsse 6 des Bauteiles 4 sind mit auf der Leiterplatte 3 angeordneten Leiterbahnen 7 -gegebenenfalls unter Zwischenschaltung von flächenhaften, flexiblen Anschlußbahnen-Folien (vgl. DE-=S 38 38 085)- verlötet.

Zwischen der Leiterplatte 3 und dem Auflager 2 befindet sich entweder eine elastische Klebstoffschicht 8, vorzugsweise aus einem Silikonkleber, oder mit 8′ angedeutete punktförmige Klebestellen (gestrichelt dargestellt) von einer Stärke von mindestens 3 mm, vorzugsweise von etwa 5 bis 10 mm. Durch die zwischen Auflage 2 und Leiterplatte 3 befindliche elastische Klebstoffschicht 8, bzw. die punktförmigen Klebestellen 8′, wird erreicht, daß sich beim Abschuß eines entsprechenden Geschosses die Leiterplatte 3 zwar aufgrund der auf sie wirkenden Beschleunigungskräfte entgegen der Flugrichtung verbiegt, daß aber durch die Klebstoffschicht 8, bzw. die punktförmigen Klebestellen 8′, diese Durchbiegung der Leiterplatte 3 gegenüber dem Auflager 2 abgefedert wird. Dieser Vorgang ist in den Fig.2 und 3 im einzelnen dargestellt:

Dabei ist in Fig.2 mit 1 wiederum die Elektronik-Baugruppe bezeichnet, die im wesentlichen senkrecht zur Achse einer Munitionshülle 9 angeordnet ist. Beim Abschuß wirken auf die Elektronik-Baugruppe 1 in Flugrichtung 10 eine Beschleunigungskaft 11 sowie eine Zentrifugalkraft 12 und eine Kraft aufgrund der Winkelbeschleunigung 13. Aus diesen Kräften ergibt sich eine resultierende Kraft 14, welche zu entsprechende in Fig. 3 dargestellte Zugkräfte 15 und Zug- und Scherkräfte 16 führt.

Wie in Fig. 3 dargestellt ist, bewirken die Zug- und Scherkräfte 15 und 16 ein Durchbiegen der Leiterplatte 3 entgegen der Flugrichtung 10 unter gleichzeitiger Verformung der Klebstoffschicht 8. Aufgrund der Dicke und Elastizität der Klebstoffschicht 8 federt diese aber die Bewegung der Leiterplatte 3 ab, so daß sich diese nicht von dem Auflager 2 abgelöst und die Funktionsfähigkeit Baugruppe 1 nicht beeinträchtigt wird.

Das elektronische Bauteil 4 kann auch von einem durch Aufkleben oder Auflöten auf der Leiterplatte 3 befestigten Rahmen aufgenommen werden, der seinerseits elektrische Anschlüsse aufweist, die die elektrischen Anschlüsse 6 des Bauteils 4 kontaktieren und mit den entsprechenden Leiterbahnen 7 verlötet ist.

Die Leiterplatte 3 und die darauf angeordneten elektronischen Bauteile 4 werden vorteilhafterweise mit einer elektrisch isolierenden Beschichtung 17 versehen, wodurch während der Abschuß- und Flugphase entstehende Resonanzen gedämpft werden und die Resistenz gegenüber Umweltbelastungen erhöht wird.

Die Beschichtung 17 kann beispielsweise durch Vergießen mit einem Kunststoff, etwa Polyurethan, durch Erzeugen einer druckgeschäumten Schicht aus Polyurethan und durch Überziehen mit einem insbesondere glasfaserverstärkten Laminat, etwa aus Epoxidharz, hergestellt werden.

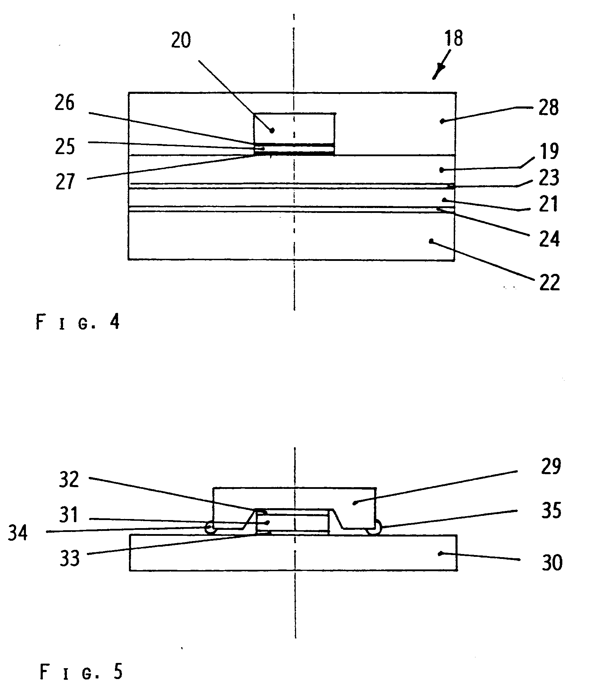

Fig.4 zeigt ein zweites Ausführungsbeispiel einer beschleunigungsfesten Elektronik-Baugruppe, welches sich in der Praxis besonders bewährt hat. Die mit 18 bezeichnete Elektronik-Baugruppe enthält eine ca.1,5 mm starke Leiterplatte 19 aus einem glasfaserverstärktem Material, auf der ein elektronisches Bauteil 20 angeordnet ist. Die Leiterplatte 19 ist über eine elastische Folie (Celasto-Folie) 21 von beispielsweise etwa 1 mm Stärke mit einem Aufleger 22 verbunden. Dabei erfolgt die Verbindung zwischen Leiterplatte 19 und Folie 21 sowie zwischen der Folie 21 und dem Auflager 22 über entsprechende Klebeschichten 23,24 eines Polyurethan-Klebers. Um eine absolute gleiche Klebestärke und eine exakte Positionierung der Leiterkarte zum Auflager 22 zu gewährleisten ist es notwendig, für den Aushärterprozess die Leiterplatte durch Aufbringen eines Gewichtes (ca. 1 kg) gleichmäßig zu belasten.

Zwischen dem elektronischen Bauteil 20 und der Leiterplatte 19 ist bei diesem Ausführungsbeispiel eine elastische Zwischenscheibe 25 als Distanzscheibe angeordnet, die mittels entsprechender Klebeschichten 26,27 an dem Bauteil 20 und der Leiterplatte 19 befestigt ist. Eine derartige Zwischenscheibe 25 empfiehlt sich insbesondere bei der Anordnung sehr großer elektronischer Bauteile (z.B. PLCC-Bauelemente).

Als Beschichtung 28 der Leiterplatte 19 mit dem elektronischen Bauteil 20 dient eine druckgeschäumte Schicht aus Polyurethan, vorzugsweise in eingehäuster Form.

In Fig. 5 ist ein Ausführungsbeispiel mit einem elektronischen Bauteil 29 dargestellt, bei dem es sich um ein randseitig abgestütztes Teil handelt. Bei Verwendung derartiger Bauteile hat es sich als vorteilhaft erwiesen, einerseits den inneren Bereich des Bauteiles mittels einer glasfaserverstärkten Kunststoffplatte 31 elastisch abzustützen, wobei die Kunststoffplatte 31 über Klebeschichten 32, 33 mit dem elektronischen Bauteil 29 und der Leiterplatte 30 verbunden ist. Andererseits erfolgt eine elastische Abstützung des Randbereiches des Bauteiles 29 mittels punktförmiger Klebestellen 34, z.B. mittels eines Epoxyharz-Klebers.

Die elektrischen Anschlüsse sind in Fig. 5 mit dem Bezugszeichen 35 angedeutet.

### Bezugszeichenliste

- 1: Elektronik-Baugruppe
- 2: Auflager
- 3: Leiterplatte
- 4: elektronisches Bauteil
- 5: Klebepunkte
- 6: elektrische Anschlüsse
- 7: Leiterbahnen
- 8: Klebstoffschicht
- 8′: punktförmige Klebestellen
- 9: Munitionshülle
- 10: Flugrichtung
- 11: Beschleunigung
- 12: Zentrifugalbeschleunigung
- 13: Winkelbeschleunigung
- 14: resultierende Kraft
- 15: Zugkraft
- 16: Scherkraft
- 17: Beschichtung
- 18: Elektronik-Baugruppe
- 19: Leiterplatte
- 20: elektronisches Bauteil
- 21: Celasto-Folie
- 22: Auflager
- 23,24: Klebeschichten
- 25: Zwischenscheibe
- 26,27: Klebeschichten
- 28: Druckschaum
- 29: elektronisches Bauteil
- 30: Leiterplatte
- 31: glasfaserverstärkte Kunststoffplatte
- 32,33: Klebeschichten
- 34: punktförmige Klebestelle
- 35: elektrischer Anschluß

## Patentansprüche

1. Elektronik-Baugruppe mit wenigstens einer mit Leiterbahnen (7) versehenen Leiterplatte (3;19;30), auf der mindestens ein elektronisches Bauteil (4;20;29) befestigt ist, dessen elektrische Anschlüsse (6;35) mit den zugehörigen Leiterbahnen (7) kontaktiert sind, **dadurch gekennzeichnet,** daß die Leiterplatte (3) über eine elastische Klebstoffschicht (8) oder über punktförmige Klebestellen (8′) aus einem elastischen Kleber mit einem Auflager (2) verbunden ist, derart daß die genannte Elektronik-Baugruppe verschußfest ist.

2. Elektronik-Baugruppe mit wenigstens einer mit Leiterbahnen (7) versehenen Leiterplatte (3;19;30), auf der mindestens ein elektronisches Bauteil (4;20;29) befestigt ist, dessen elektrische Anschlüsse (6;35) mit den zugehörigen Leiterbahnen (7) kontaktiert sind, **dadurch gekennzeichnet,** daß die Leiterplatte (19) über eine elastische Folie (21), vorzugsweise aus einem geschäumten Polyurethan-Elastomer, mit einem Auflager (2) verbunden ist, wobei die elastische Folie (21) mittels eines Polyurethan-Klebers (23,24) an der Leiterplatte (19) und dem Auflager (2) befestigt ist, derart daß die genannte Elektronik-Baugruppe verschußfest ist.

3. Verschußfeste Elektronik-Baugruppe, nach Anspruch 2, **dadurch gekennzeichnet,** daß die elastische Folie (21) eine Stärke von 0,5 bis 3 mm, vorzugsweise 1 bis 2 mm, aufweist.

4. Verschußfeste Elektronik-Baugruppe nach Anspruch 1, **dadurch gekennzeichnet,** daß die Klebstoffschicht (8) bzw. die punktförmigen Klebstoffstellen (8′) eine Stärke von mindestens 3 mm, vorzugsweise eine Stärke von etwa 5 bis 10 mm, aufweist ( bzw. aufweisen).

5. Verschußfeste Elektronik-Baugruppe nach einem der Ansprüche 1 bis 4, **dadurch gekennzeichnet,** daß die Leiterplatte (3,19,30) aus einem glasfaser- oder kohlefaserverstärktem Kunststoffmaterial oder aus einem Keramik-Hybrid-Material besteht.

6. Verschußfeste Elektronik-Baugruppe nach einem der Ansprüche 1 bis 4, **dadurch gekennzeichnet,** daß die Leiterplatte (3,19,30) aus einem Stahlhybrid-Material besteht.

7. Verschußfeste Elektronik-Baugruppe nach einem der Ansprüche 1 bis 6, **dadurch gekennzeichnet,** daß zwischen dem elektronischen Bauteil (20) und der Leiterplatte (19) eine elastische Zwischenscheibe (25) geklebt ist.

8. Verschußfeste Elektronik-Baugruppe nach einem der Ansprüche 1 bis 7, **dadurch gekennzeichnet,** daß bei abzustützenden elektronischen Bauteilen (29) zwischen dem jeweiligen Bauteil (29) und der Leiterplatte (30) eine glasfaserverstärkte Kunststoffplatte (31) angeordnet ist, die sowohl mit dem elektronischen Bauteil (29) als auch mit der Leiterplatte (30) über eine Klebeschicht (32,33) verbunden ist.

9. Verschußfeste Elektronik-Baugruppe nach einem der Ansprüche 1 bis 8, **dadurch gekennzeichnet,** daß die Leiterplatte (3;19;30) und das darauf angeordnete elektronische Bauteil (4;20;29) mit einer elektrisch isolierenden Beschichtung (17;28) versehen sind.

## Claims

1. Electronic constructional sub-assembly with at least one circuit board (3,19,30) which is provided with conductors (7) and to which is affixed at least one electronic component (4,20,29) of which the electrical connections (6,35) are contacted with the associated conductors (7), characterised by the fact that the circuit board (3) is connected to a support (2) via an elastic adhesive coating (8) or via adhesive points (8′) of an elastic adhesive, in such a way that the said electronic sub-assembly is resistant to damage from the firing.

2. Electronic constructional sub-assembly with at least one circuit board (3,19,30) which is provided with conductors (7) and to which is affixed at least one electronic component (4,20,29) of which the electrical connections (6,35) are contacted with the associated conductors (7), characterised by the fact that the circuit board (19) is connected to a support (2) via an elastic film (21), preferably of a foamed polyurethane elastomer, the elastic film (21) being affixed to the circuit board (19) and the support (2) by means of a polyurethane adhesive (23,24), in such a way that the said electronic constructional assembly is resistant to damage from firing.

3. Electronic constructional sub-assembly resistant to damage from firing, in accordance with Claim 2, characterised by the fact that the elastic foil (21) has a thickness of 0.5 to 3 mm, preferably 1 to 2 mm.

4. Electronic constructional sub-assembly, resistant to damage from firing, in accordance with Claim 1, characterised by the fact that the adhesive coating (8) or the adhesive points (8′) has a thickness of at least 3 mm, preferably about 5 to 10 mm.

5. Electronic constructional sub-assembly, resistant to damage from firing, in accordance with any one of Claims 1 to 4, characterised by the fact that the circuit board (3,19,30) consists of a fibre glass or carbon fibre reinforced plastic material or of a ceramic hybrid material.

6. Electronic constructional sub-assembly, resistant to damage from firing, in accordance with any one of Claims 1 to 4, characterised by the fact that the circuit board (3,19,30) consists of a steel hybrid material.

7. Electronic constructional sub-assembly, resistant to firing, in accordance with any one of Claims 1 to 6, characterised by the fact that an intermediate elastic disc (25) is affixed by means of an adhesive between the electronic component (20) and the circuit board (19).

8. Electronic constructional assembly, resistant to damage from firing, in accordance with any one of Claims 1 to 7, characterised by the fact that, in the case of electronic components (29) to be supported, a fibre glass reinforced plastic plate (31) is provided in each case between the relevant component (29) and the circuit board (30) and is connected both with the electronic component (29) and with the circuit board (30) via an adhesive coating (32,33).

9. Electronic constructional sub-assembly, resistant to damage from firing, in accordance with any one of Claims 1 to 8, characterised by the fact that the circuit board (3,19,30) and the electronic component (4,20,29) mounted thereon are provided with an electrically non-conductive coating (17,28).

## Revendications

1. Ensemble électronique comportant au moins une carte imprimée (3; 19 ; 30) munie de pistes conductrices (7), sur laquelle est fixé au moins un composant électronique (4 ; 20; 29), dont les raccordements électriques (6 ; 35) sont mis en contact avec les pistes associées (7) caractérisé en ce que la carte imprimée (3) est reliée à un support (2) par l'intermédiaire d'une couche adhésive (8) élastique ou de points de colle (8′) constitués par un adhésif élastique, de telle sorte que l'ensemble électronique précité est résistant au tir.

2. Ensemble électronique comportant au moins une carte imprimée (3; 19 ; 30) munie de pistes conductrices (7), sur laquelle est fixé au moins un composant électronique (4; 20; 29), dont les raccordements électriques (6 ; 35) sont mis en contact avec les pistes associées (7), caractérisé en ce que la carte imprimée (19) est reliée par l'intermédiaire d'un film élastique (21), de préférence en un élastomère de polyuréthanne expansé, à un support (2), le film élastique (21) étant fixé au moyen d'un adhésif polyuréthanne (23, 24) sur la carte imprimée (19) et le support (2), de telle sorte que l'ensemble électronique précité est résistant au tir.

3. Ensemble électronique résistant au tir selon la revendication 2, caractérisé en ce que le film élastique (21) a une épaisseur de 0,5 à 3 mm, de préférence de 1 à 2 mm.

4. Ensemble électronique résistant au tir selon la revendication 1, caractérisé en ce que la couche d'adhésif (8) et/ou les points de colle (8′) ont une épaisseur d'au moins 3 mm, de préférence une épaisseur d'environ 5 à 10 mm.

5. Ensemble électronique résistant au tir selon l'une des revendications 1 à 4, caractérisé en ce que la carte imprimée (3, 19, 30) est en un matériau renforcé de fibres de verre ou de fibres de carbone ou en un matériau céramique hybride.

6. Ensemble électronique résistant au tir selon l'une des revendications 1 à 4, caractérisé en ce que la carte imprimée (3, 19, 30) est en un matériau acier hybride.

7. Ensemble électronique résistant au tir selon l'une des revendications 1 à 6, caractérisé en ce qu'un disque intercalaire (25) élastique est collé entre le composant électronique (20) et la carte imprimée (19).

8. Ensemble électronique résistant au tir selon l'une des revendications 1 à 7, caractérisé en ce qu'avec les composants électroniques (29) qui doivent être soutenus, on place entre le composant électronique (29) et la carte imprimée (30) une plaquette de matière plastique (31) renforcée de fibres de verre, qui est reliée par une couche adhésive (32, 33) aussi bien au composant électronique (29) qu'à la carte imprimée (30).

9. Ensemble électronique résistant au tir selon l'une des revendications 1 à 8, caractérisé en ce que la carte imprimée (3, 19, 30) et le composant électronique (4, 20, 29) placé sur celle-ci sont munis d'une couche électriquement isolante (17, 28).
